# EUROPÄISCHE PATENTSCHRIFT

(11) **EP 1 803 339 B1**
(45) Veröffentlichungstag und Bekanntmachung des Hinweises auf die Patenterteilung: **03.03.2010**
(21) Anmeldenummer: 05782862.6
(22) Anmeldetag: 09.09.2005
(51) Int. Cl.: H05K 5/02, G09F 7/18, G09F 3/18, H02B 1/30

(54) **GEHÄUSE ODER RAHMENARTIGE AUFNAHMEEINHEIT**
HOUSING OR FRAME-LIKE HOLDING ELEMENT WITH AN INSCRIBED STRIP
BOITIER OU UNITE DE RECEPTION DE TYPE BAIE, A BAGUETTE DE MARQUAGE

(30) Priorität: 15.10.2004 DE 102004050498
(43) Veröffentlichungstag der Anmeldung: 04.07.2007
(73) Patentinhaber: Rittal GmbH & Co. KG, 35745 Herborn (DE)
(72) Erfinder: BESSERER, Horst, 35745 Herborn (DE); LANG, Martin, 35759 Driedorf (DE)
(74) Vertreter: Fleck, Hermann-Josef
(86) Internationale Anmeldenummer: PCT/EP2005/009707
(87) Internationale Veröffentlichungsnummer: WO 2006/042591

(56) Entgegenhaltungen:
- EP-A- 0 902 515
- DE-A1- 3 403 114
- DE-U1- 9 421 342

## Beschreibung

Die Erfindung bezieht sich auf ein Gehäuse oder eine rahmenartige Aufnahmeeinheit für insbesondere elektronische oder elektrische Komponenten mit einem eine Öffnung umgebenden Rahmen und einer in der Frontseite mindestens eines Profils in Längsrichtung ausgebildeten Aufnahme und einer in diese eingesetzten Beschriftungsleiste, die einen Haltestreifen trägt, welcher eine Frontseite liegende Sichtfläche bildet.

Ein derartiges Gehäuse mit Beschriftungsleiste ist in der DE 94 21 342 U1 angegeben, wobei es sich um einen Schaltschrank handelt. Hierbei sind Seitenverkleidungsteile vorgesehen, die randseitig mit von der Frontseite Z-förmig nach hinten abgekanteten Abschnitten versehen sind, in die ein Profilstück eingesetzt ist, das auf seiner Frontseite mit einer Aufnahme in Form einer nutförmigen Vertiefung für die Beschriftungsleiste versehen ist. Die Beschriftungsleiste selbst besteht aus einem flachen transparenten Haltestreifen, hinter dem ein Schriftträger angeordnet ist, wobei die Beschriftungsleiste von der Stirnseite in Längsrichtung in die Nut eingeschoben wird und ihre beiden Längsränder von gegeneinander gerichteten Randabschnitten der C-förmigen Nut übergriffen werden. Diese Ausbildung erfordert einen entsprechenden Teile- und Montageaufwand und ist geeignet für Erfordernisse von Schaltschränken, die mit Blechwänden verkleidet werden.

Nach der DE 34 03 114 A1 werden ebenfalls bei einem Gehäuseschrank Beschriftungsstreifen in eine Blechverkleidung eingesetzt, wobei in dem Blechzuschnitt Z-förmig gebogene Lappen die Vertiefung für ein zur Frontseite offenes U-förmiges metallisches Profilstück bilden, in dem die Beschriftungsleiste aufgenommen wird.

Die CH 610 463 A5 zeigt eine auswechselbare elektronische Baugruppe, an deren vorderer Stirnseite ein Profilstück mit einer Aufnahme für eine Beschriftung angeordnet ist. Die CH 429 872 schlägt vor, hinter einer Gehäuseöffnung einen mit verschiedenen Bezeichnungen versehenen bandförmigen Träger in einer Schiebeführung verstellbar anzuordnen.

In der DE 1 749 079 U1 ist eine Zierleiste für Gerätegehäuse angegeben, die durch die Verbindung einer Kunststoffleiste gebildet ist, bei der ein eingelegtes Metallfolienband von durchsichtigem Kunststoff umschlossen ist.

Der Erfindung liegt die Aufgabe zugrunde, ein Gehäuse oder eine rahmenartige Aufnahmeeinheit derart weiterzubilden, dass das Gehäuse bzw. die Aufnahmeeinheit mit möglichst wenig Aufwand mit einer Beschriftungsleiste ausrüstbar ist.

Diese Aufgabe wird mit den Merkmalen des Anspruches 1 gelöst. Hierbei ist vorgesehen, dass den Rahmen bildende Rahmenschenkel als Rahmenprofile ausgebildet sind, von denen an mindestens einem die Aufnahme für die Beschriftungsleiste ausgebildet ist, und dass der Haltestreifen auf seiner von der Sichtseite abgekehrten Rückseite mit zwei längs verlaufenden, zueinander parallelen federnden Raststegen mit Rastelementen versehen ist, die in an der Aufnahme ausgebildeten Rastgegenelementen rastend eingreifen.

Dabei wird ein einfaches Anbringen und Austauschen dadurch begünstigt, dass der Haltestreifen im Querschnitt im Wesentlichen U-förmig ausgebildet ist, wobei die Raststege die U-Schenkel bilden, und dass die Sichtfläche selbst die Beschriftung trägt oder transparent ausgebildet ist, um einen hinter derselben zwischen den Raststegen eingelegten Schriftträger sichtbar zu machen.

Verschiedene vorteilhafte Ausgestaltungen für die Fertigung und Montage bestehen darin, dass die Aufnahme als nutförmige Vertiefung mit zwei sich gegenüberliegenden seitlichen Begrenzungen ausgebildet ist, an denen die Rastgegenelemente als längs verlaufende Vertiefungen oder vorstehende Rippen ausgebildet sind, in welche die auf der Außenseite der Raststege angeordneten, als Rippen oder umgekehrt als Vertiefungen ausgebildeten Rastelemente rastend eingreifen, oder dass die Aufnahme als Vorsprung ausgebildet ist, auf dessen voneinander abgelegenen, in Längsrichtung verlaufenden Seitenflanken die Rastgegenelemente ausgebildet sind, in die dann die auf der Innenseite der Raststege ausgebildeten Rastelemente eingreifen.

Ist vorgesehen, dass auf der Innenseite der Raststege sich gegenüberliegende, längs verlaufende Haltenuten eingeformt sind, in die der Schriftträger mit seinen Längsrändern hineinragt, so kann der Schriftträger bereits vor der Montage der Beschriftungsleiste an dem Gehäuse leicht in den Haltestreifen eingefügt und zusammen mit diesem auf einfache Weise montiert werden.

Zu einer einfachen Anbringung tragen weiterhin die Maßnahmen bei, dass die seitlichen Begrenzungen der nutförmigen Vertiefung mit von außen nach innen bezüglich der Einsetzrichtung der Beschriftungsleiste spitzwinklig aufeinander zulaufenden Einführschrägen oder Einführkurven versehen sind, hinter denen die Rastgegenelemente angeordnet sind.

Mit den Maßnahmen, dass die Sichtfläche (bzw. Frontwand) des Haltestreifens entlang ihren beiden Längsseiten über die Ansätze der U-Schenkel hinaus mit Auflagerändern verlängert sind und dass die Aufnahme an ihrer offenen Außenseite Ausnehmungen trägt, die an die Auflageränder in Breite und Tiefe im Wesentlichen angepasst sind und in Einsetzrichtung der Beschriftungsleiste auf ihrer Rückseite eine Anlage aufweisen, wird ein eindeutiger, auf der Vorderseite flächenbündiger Sitz der Beschriftungsleiste gewährleistet und auch ein Schutz vor einem Eindringen von Schmutz erhalten.

Zusätzliche Befestigungsmöglichkeiten ergeben sich dadurch, dass im Nutgrund der als nutförmige Vertiefung ausgebildeten Aufnahme eine längs verlaufende Gewindenut eingebracht ist.

Ist vorgesehen, dass das Rahmenprofil auf beiden Längsseiten der Aufnahme anschließend frontseitige Flächenbereiche trägt und dass der der Öffnung näher liegende Flächenbereich über einen bezüglich der Frontseite zurückspringenden Absatz in einen die Öffnung begrenzenden, zu der Öffnungsebene parallelen flanschartigen Anlagesteg übergeht, wird eine flächige Integration der Beschriftungsleiste in der Frontseite erreicht, die die mit einer Platte bzw. Einsatz verschließbare Öffnung als breiter Rahmen umgibt.

Der Gehäuseaufbau bzw. Aufbau der Aufnahmeeinheit unter Integration der Aufnahme für die Beschriftungsleiste wird des Weiteren dadurch begünstigt, dass das Rahmenprofil mit einem einstückig angeformten, bezüglich der Frontseite nach hinten in die Tiefe ragenden Wandabschnitt des Gehäuses oder der Aufnahmeeinheit versehen ist.

Ein vorzugsweise flaches einfach zusammenbaubares Gehäuse, das in der Tiefe erweiterbar ist und in dem auf der Frontseite an unterschiedlichen Stellen Beschriftungsleisten anbringbar sind, wobei ein umlaufender Rahmen mit einem einheitlichen optischen Gesamteindruck erhalten wird, ergibt sich dadurch, dass der jeweilige Wandabschnitt mehrere in Längsrichtung verlaufende Hohlräume aufweist und dass ein oberes, ein unteres und zwei seitliche Rahmenprofile jeweils des gleichen Querschnitts über vier gleiche Eckstücke miteinander verbunden sind, deren frontseitigen Flächenbereiche glatt in die frontseitigen Flächenbereiche der Rahmenprofile übergehen.

Die Erfindung wird nachfolgend anhand von Ausführungsbeispielen unter Bezugnahme auf die Zeichnungen näher erläutert. Es zeigen:
- Fig. 1: ein Gehäuse mit gleichen Rahmenprofilen und einer Beschriftungsleiste in perspektivischer Ansicht,
- Fig. 2: eine Beschriftungsleiste in perspektivischer Ansicht,
- Fig. 3: einen Rahmenprofilabschnitt des Gehäuses mit eingesetzter Beschriflungsleiste im Querschnitt und
- Fig. 4: ein Rahmenprofil des Gehäuses mit eingesetzter Beschriftungsleiste im Querschnitt.

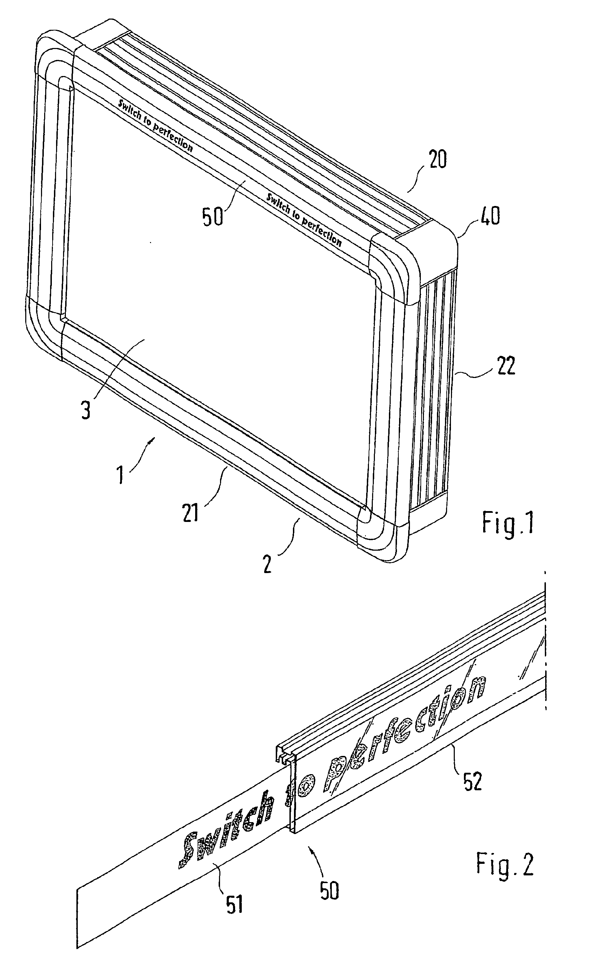

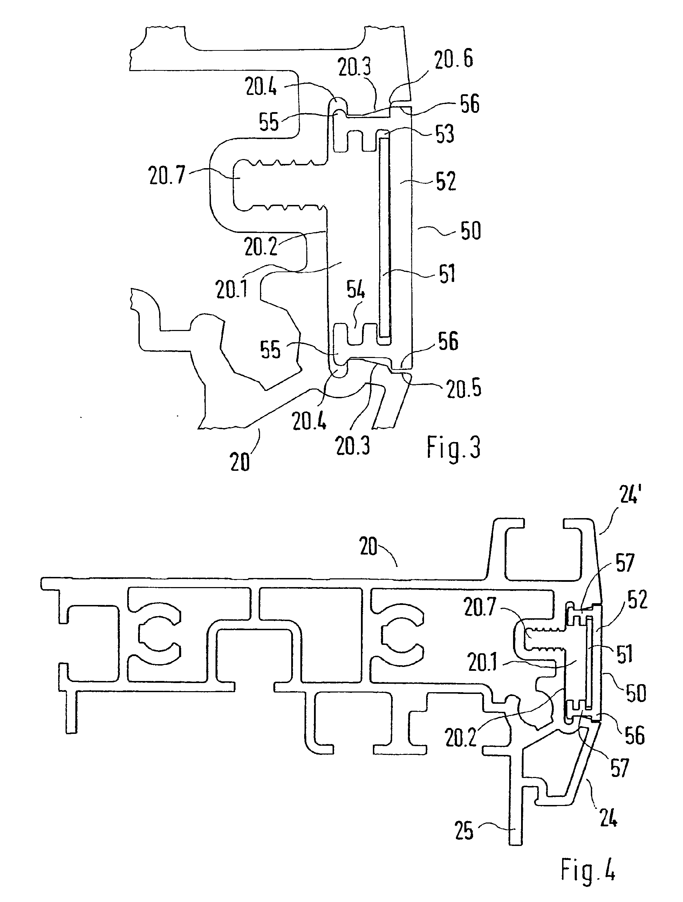

Ein in Fig. 1 gezeigtes, flach ausgebildetes, im Wesentlichen quaderförmiges Gehäuse 1 weist einen eine Gehäuseöffnung 3 allseitig umschließenden Rahmen 2 aus vier Rahmenschenkeln aus einem gleichen Rahmenprofil auf, nämlich einem oberen Rahmenprofil 20, einem unteren Rahmenprofil 21 und zwei seitlichen Rahmenprofilen 22, die mittels Eckstücken 40 in den Kantenbereichen miteinander verbunden sind. Die den vorliegend rechteckförmigen Rahmen 2 umschließenden Rahmenprofile 20, 21, 22 weisen frontseitig relativ breite Rahmenabschnitte auf, in denen jeweils eine Aufnahme 20.1 in Form einer nutförmigen Vertiefung eingeformt ist, wobei vorliegend lediglich in die Aufnahme 20.1 des oberen Rahmenprofils 20 eine Beschriftungsleiste 50 eingesetzt ist. Die frontseitigen Abschnitte der Rahmenprofile 20, 21, 22 gehen auf ihrer Rückseite einstückig in einen nach hinten ragenden oberen und unteren und zwei seitliche Wandabschnitte des flachen Gehäuses 1 über, wie auch aus Fig. 4, die einen Querschnitt des gesamten Rahmenprofils zeigt, ersichtlich ist. Die Eckstücke 40 ergänzen sowohl den Frontabschnitt der Rahmenprofile 20, 21, 22 als auch deren Wandabschnitte in den Kantenbereichen auch optisch zu einer umlaufenden Einheit.

Wie die Fig. 3 und 4 im Querschnitt zeigen, sind die Aufnahmen 20.1 im Wesentlichen als flache, U-förmige Vertiefungen in den Frontabschnitten der Rahmenprofile 20, 21, 22 in der Frontseite eingeformt und von seitlichen Begrenzungen sowie einem Nutgrund 20.2 begrenzt und zur Frontseite hin offen. An die seitlichen Begrenzungen schließen sich nach innen zur Öffnung 3 hin und nach außen zum äußeren Rand des Rahmens 2 hin frontseitige, etwas nach hinten abgeschrägte Flächenbereiche 24, 24' an, so dass der Frontabschnitt zur Frontseite hin in Verbindung mit einer eingesetzten Beschriftungsleiste 50 relativ großflächig erscheint und die Beschriftungsleiset markant hervortritt. Der innere frontseitige Flächenbereich 24 geht über einen zurückspringenden Absatz in einen die Öffnung 3 mit ihrem freien Rand umschließenden leistenartigen Anlagesteg 25 über, so dass an dem Anlagesteg 25 auf einfache Weise eine Abdeckung der Öffnung 3 angebracht werden kann. Zum einfachen Verbinden der Rahmenprofile 20, 21, 22 mittels der Eckstücke 40 weisen die Rahmenprofile 20, 21, 22 insbesondere auch in ihren Wandabschnittbereichen mehrere über ihre Länge verlaufende Hohlkammern und/oder Gewindekanäle auf.

Die seitlichen Begrenzungen der nutförmigen Aufnahme 20.1 sind mit von außen nach innen bezüglich einer Flächennormalen zur Frontseite spitzwinklig aufeinander zulaufenden Einführschrägen 20.3 versehen, hinter denen seitliche Hinterschneidungen 20.4 als Rastgegenelemente für Rastelemente 55 der Beschriftungsleiste 50 eingeformt sind. Zur Frontseite hin gehen die seitlichen Begrenzungen der Aufnahme 20.1 jeweils in eine Ausnehmung 20.5 über, die auf ihrer von der Frontseite abgewandten Rückseite eine Anlage 20.6 bildet. In dem Nutgrund 20.2 ist eine ebenfalls über die Länge verlaufende Gewindenut 20.7 eingeformt.

Die Beschriftungsleiste 50 weist einen im Querschnitt im Wesentlichen U-förmigen Haltestreifen 52 auf, der entweder selbst mit einer Beschriftung versehen werden kann oder, wie in den Fig. 2, 3 und 4 dargestellt, einen blattförmigen Schriftträger 21 auf der Rückseite der dann transparenten Sichtfläche 52.1 aufnimmt. Zum einfachen Einschieben der Schriftträger 51, die beliebige Informationen oder andere Darstellungen tragen können, sind auf der Innenseite der beiden U-Schenkel seitliche, sich gegenüberliegende Haltenuten 53 und vorliegend auch eine, von der Frontseite aus gesehen zurückversetzte, weitere Haltenut 54 eingebracht. Der mit den freien Enden der U-Schenkel in die Aufnahme 20.1 einzusetzende Haltestreifen 52 weist auf seiner Frontseite in Verlängerung der Sichtfläche 52.1 beidseitig über die Ansatzstellen der U-Schenkel hinausragende Auflageränder 56 auf, die an die Ausnehmung 20.5 der Aufnahme 20.1 angepasst sind und mit ihrer Rückseite im eingesetzten Zustand der Beschriftungsleiste 50 an der Anlage 20.6 der Ausnehmung 20.5 anliegen. Dabei ist die Tiefe der Ausnehmung 20.5 bis zur Anlage 20.6 an die Stärke der Auflageränder 56 des Haltestreifens 52 angepasst, so dass auf der Frontseite des Rahmenprofils 20, 21 bzw. 22 ein flächenbündiger Übergang entsteht. Die U-Schenkel des Haltestreifens 52 sind als federnde Raststege ausgebildet, an deren freien Endbereichen auf der Außenseite nach außen vorspringende Rastelemente 55 angeformt sind, die im eingesetzten Zustand des Haltestreifens 52 unter Federkraft in die Hinterschneidungen bzw. Rastgegenelemente 20.4 der Aufnahme 20.1 eingreifen, wie Fig. 3 zeigt. Die durch die U-Schenkel gebildeten Raststege 57 werden beim Einführen des Haltestreifens 52 von der Frontseite her entgegen ihrer Federkraft mittels der Einführschrägen 20.3 nach innen gegeneinander ausgelenkt und greifen im eingesetzten Zustand mit ihren Rastelementen 55 in die Hinterschneidungen 20.4 rastend ein. Die Rastelemente 55 und Hinterschneidungen 20.4 sind dabei vorteilhaft so geformt, dass die Haltestreifen 52 z.B. mittels eines stirnseitig hinter die Haltestreifen eingesetzten Werkzeugs gelöst und herausgenommen werden können, wobei die Raststege 57 gegen die Federkraft einschwenken. Ähnlich ist auch eine nicht oder schwer lösbare Rastverbindung mit entsprechender Gestaltung der Rastelemente und Rastgegenelemente möglich.

Die Frontseiten der Eckstücke 40 sind mit einer ähnlichen Außenkontur versehen wie die Frontseite der Rahmenprofile 20, 21, 22, um einen harmonischen Übergang zu den Frontseiten der Rahmenprofile zu schaffen, so dass ein gleichbleibender umlaufender optischer Gesamteindruck entsteht. Nicht benötigte Aufnahmen 20.1 in z.B. den seitlichen und dem unteren Rahmenprofil 21 bzw. 22 können auch mit undurchsichtigen Verschlussleisten eines entsprechenden Querschnitts wie die Haltestreifen 52 verschlossen werden. Auch besteht die Möglichkeit, z.B. durch örtliche Bohrungen einer derartigen Verschlussleiste oder auch des Haltestreifens 52 diese selbst oder Bedienungselemente oder dgl. mittels der Gewindenut 20.7 und eingedrehter Schrauben zu befestigen. Die Haltestreifen 52 bestehen vorteilhaft aus Kunststoff, können jedoch auch aus nachgiebigem Metall z.B. mit Sichtfenster oder aus Glas hergestellt sein.

Alternative Ausgestaltungsmöglichkeiten der Aufnahme 20.1 und Beschriftungsleiste 50 sind in den Ansprüchen und der Beschreibungseinleitung angegeben.

## Patentansprüche

1. Gehäuse oder rahmenartige Aufnahmeeinheit für insbesondere elektronische oder elektrische Komponenten mit einem eine Öffnung (3) umgebenden Rahmen (2) und einer in der Frontseite mindestens eines Profils in dessen Frontseite in Längsrichtung ausgebildeten Aufnahme (20.1) und einer in diese eingesetzten Beschriftungsleiste (50), die einen Haltestreifen (52) trägt, welcher eine zur Frontseite liegende Sichtfläche (52.1) bildet,
**dadurch gekennzeichnet,**
**dass** den Rahmen (2) bildende Rahmenschenkel als Rahmenprofile (20, 21, 22) ausgebildet sind, von denen an mindestens einem die Aufnahme (20.1) für die Beschriftungsleiste (50) ausgebildet ist, und
**dass** der Haltestreifen auf seiner von der Sichtseite abgekehrten Rückseite mit zwei längs verlaufenden, zueinander parallelen federnden Raststegen (20.8) mit Rastelementen (55) versehen ist, die in an der Aufnahme (20.1) ausgebildeten Rastgegenelementen (20.4) rastend eingreifen.

2. Gehäuse oder Aufnahmeeinheit nach Anspruch 1,
**dadurch gekennzeichnet,**
**dass** der Haltestreifen (52) im Querschnitt im Wesentlichen U-förmig ausgebildet ist, wobei die Raststege (20.8) die U-Schenkel bilden, und
**dass** die Sichtfläche (52.1) selbst die Beschriftung trägt oder transparent ausgebildet ist, um einen hinter derselben zwischen den Raststegen (20.8) eingelegten Schriftträger (51) sichtbar zu machen.

3. Gehäuse oder Aufnahmeeinheit nach Anspruch 1 oder 2,
**dadurch gekennzeichnet,**
**dass** die Aufnahme (20.1) als nutförmige Vertiefung mit zwei sich gegenüberliegenden seitlichen Begrenzungen ausgebildet ist, an denen die Rastgegenelemente (20.4) als längs verlaufende Vertiefungen oder vorstehende Rippen ausgebildet sind, in welche die auf der Außenseite der Raststege (20.8) angeordneten, als Rippen oder umgekehrt als Vertiefungen ausgebildeten Rastelemente (55) rastend eingreifen, oder
**dass** die Aufnahme (20.1) als Vorsprung ausgebildet ist, auf dessen voneinander abgelegenen, in Längsrichtung verlaufenden Seitenflanken die Rastgegenelemente ausgebildet sind, in die dann die auf der Innenseite der Raststege (20.8) ausgebildeten Rastelemente (55) eingreifen.

4. Gehäuse oder Aufnahmeeinheit nach Anspruch 2 oder 3,
**dadurch gekennzeichnet,**
**dass** auf der Innenseite der Raststege (20.8) sich gegenüberliegende, längs verlaufende Haltenuten (53) eingeformt sind, in die der Schriftträger (51) mit seinen Längsrändern hineinragt.

5. Gehäuse oder Aufnahmeeinheit nach Anspruch 3 oder 4,
**dadurch gekennzeichnet,**
**dass** die seitlichen Begrenzungen der nutförmigen Vertiefung mit von außen nach innen bezüglich der Einsetzrichtung der Beschriftungsleiste (50) spitzwinklig aufeinander zulaufenden Einführschrägen (20.3) oder Einführkurven versehen sind, hinter denen die Rastgegenelemente (20.4) angeordnet sind.

6. Gehäuse oder Aufnahmeeinheit nach einem der Ansprüche 2 bis 5,
**dadurch gekennzeichnet,**
**dass** die Sichtfläche (52.1) entlang ihren beiden Längsseiten über die Ansätze der U-Schenkel hinaus mit Auflagerändern (56) verlängert sind und
**dass** die Aufnahme (20.1) an ihrer offenen Außenseite Ausnehmungen (20.5) trägt, die an die Auflageränder (56) in Breite und Tiefe im Wesentlichen angepasst sind und in Einsetzrichtung der Beschriftungsleiste (50) auf ihrer Rückseite eine Anlage (20.5) aufweisen.

7. Gehäuse oder Aufnahmeeinheit nach einem der Ansprüche 3 bis 6,
**dadurch gekennzeichnet,**
**dass** im Nutgrund der als nutförmige Vertiefung ausgebildeten Aufnahme (20.1) eine längs verlaufende Gewindenut (20.7) eingebracht ist.

8. Gehäuse oder Aufnahmeeinheit nach einem der vorhergehenden Ansprüche,
**dadurch gekennzeichnet,**
**dass** das Rahmenprofil auf beiden Längsseiten der Aufnahme (20.1) anschließend frontseitige Flächenbereiche trägt (24, 24') und
**dass** der der Öffnung (3) näher liegende Flächenbereich (24) über einen bezüglich der Frontseite zurückspringenden Absatz in einen die Öffnung (3) begrenzenden, zu der Öffnungsebene parallelen flanschartigen Anlagesteg (25) übergeht.

9. Gehäuse oder Aufnahmeeinheit nach einem der vorhergehenden Ansprüche,
**dadurch gekennzeichnet,**
**dass** das Rahmenprofil mit einem einstückig angeformten, bezüglich der Frontseite nach hinten in die Tiefe ragenden Wandabschnitt des Gehäuses (1) oder der Aufnahmeeinheit versehen ist.

10. Gehäuse oder Aufnahmeeinheit nach Anspruch 9,
**dadurch gekennzeichnet,**
**dass** der jeweilige Wandabschnitt mehrere in Längsrichtung verlaufende Hohlräume aufweist und
**dass** ein oberes (20), ein unteres (21) und zwei seitliche Rahmenprofile (22) jeweils des gleichen Querschnitts über vier gleiche Eckstücke (40) miteinander verbunden sind, deren frontseitigen Flächenbereiche glatt in die frontseitigen Flächenbereiche der Rahmenprofile (20, 21, 22) übergehen.

## Claims

1. Housing or frame-like holding unit for, in particular, electronic or electrical components, with a frame (2) which surrounds an opening (3), a holding fixture (20.1) which is formed in the longitudinal direction in the front side of at least one profile, and an inscribed strip (50) which is inserted into the holding fixture and which supports a holding strip (52), which holding strip (52) forms a viewing surface (52.1) on the front side,
**characterised in that**
frame limbs which form the frame (2) are formed as frame profiles (20, 21, 22), on at least one of which the holding fixture (20.1) for the inscribed strip (50) is formed and
the back side of the holding strip facing away from the viewing side is provided with two longitudinally extending resilient detent webs (20.8) parallel to each other with detent elements (55), which detent elements (55) engage in a detent fashion with detent mating elements (20.4) formed on the holding fixture (20.1).

2. Housing or holding unit according to Claim 1,
**characterised in that**
the holding strip (52) has an essentially U-shaped cross-section, the detent webs (20.8) forming the U-limbs, and that the viewing surface (52.1) itself supports inscription or is formed transparent to permit an inscription support (51) to be viewed when inserted between the detent webs (20.8) behind the viewing surface.

3. Housing or holding unit according to Claim 1 or 2,
**characterised in that**
the holding fixture (20.1) is formed as a groove-shaped recess with two opposing lateral boundaries on which the detent mating elements (20.4) are formed as longitudinally extending recesses or protruding ribs, which are engaged in a detent fashion by the detent elements (55) which are formed as ribs or reversely as recesses and are arranged on the outside of the detent webs (20.8), or that
the holding fixture (20.1) is formed as a projection on the longitudinally extending lateral flanks oriented away from each other on which the detent mating elements are formed which are then engaged by the detent elements (55) formed on the inside of the detent webs (20.8).

4. Housing or holding unit according to Claim 2 or 3,
**characterised in that**
opposing longitudinally extending holding grooves (53) are formed into the inside of the detent webs (20.8), into which holding grooves (53) longitudinal edges of the inscription support (51) protrude.

5. Housing or holding unit according to Claim 3 or 4,
**characterised in that**
the lateral boundaries of the groove-shaped recess having insertion bevels (20.3) or insertion curves which taper acutely inwardly from the outside toward each other in relation to the insertion direction of the inscribed strip (50), behind which insertion bevels (20.3) or insertion curves the detent mating elements (20.4) are arranged.

6. Housing or holding unit according to one of Claims 2 to 5,
**characterised in that**
both longitudinal sides of the viewing surface (52.1) are extended with contact edges (56) beyond the beginnings of the U-limbs and
that an open outside of the holding fixture (20.1) supports recesses (20.5) which are essentially adapted to the contact edges (56) in terms of width and depth and have a support surface (20.5) on a back side in an insertion direction of the inscribed strip (50).

7. Housing or holding unit according to one of Claims 3 to 6,
**characterised in that**
a longitudinally extending threaded groove (20.7) is accommodated in the groove bottom of the holding fixture (20.1) which is formed as a groove-shaped recess.

8. Housing or holding unit according to one of the preceding claims,
**characterised in that**
the frame profile supports frontal surface regions (24, 24') adjoining both longitudinal sides of the holding fixture (20.1) and
the surface region (24) situated closer to the opening (3) via a shoulder, recessed relative to the front side, transitions into a flange-like support web (25) which is parallel to a plane of the opening and delimits the opening (3).

9. Housing or holding unit according to one of the preceding claims,
**characterised in that**
the frame profile is provided with a wall section of the housing (1) or of the holding unit integrally joined and protruding backwards in a depth direction relative to the front side.

10. Housing or holding unit according to Claim 9,
**characterised in that**
each respective wall section has a plurality of cavities extending in the longitudinal direction and
that an upper frame profile (20), a lower frame profile (21), and two side frame profiles (22), each with the same cross section, are connected by four identical corner pieces (40) with frontal surface regions which transition smoothly into the frontal surface regions of the frame profiles (20, 21, 22).

## Revendications

1. Boîtier ou unité réceptrice du genre cadre pour des composants notamment électroniques ou électriques, avec un cadre (2) entourant une ouverture (3), avec un logement (20.1) formé en direction longitudinale dans la face avant d'au moins un profilé, et avec une réglette de marquage (50) insérée dans ce logement, laquelle porte une bande de maintien (52) qui forme une face de visualisation (52.1) tournée vers la face avant,
**caractérisé en ce que** les branches de cadre formant le cadre (2) sont réalisées sous la forme de profilés de cadre (20, 21, 22), sur au moins un desquels est formé le logement (20.1) pour la réglette de marquage (50),
et **en ce que** la bande de maintien est pourvue, sur sa face arrière opposée à la face de visualisation, de deux barrettes d'enclenchement (20.8) à effet de ressort, s'étendant longitudinalement, parallèles entre elles et pourvues d'éléments d'enclenchement (55) qui s'enclenchent dans des éléments complémentaires d'enclenchement (20.4) formés sur le logement (20.1).

2. Boîtier ou unité réceptrice selon la revendication 1, **caractérisé en ce que** la bande de maintien (52) est réalisée essentiellement en forme de U en coupe transversale, sachant que les barrettes d'enclenchement (20.8) forment les branches du U, et **en ce que** la face de visualisation (52.1) porte elle-même le marquage ou est réalisée transparente, afin de rendre visible un support de marquage (51) mis en place derrière elle entre les barrettes d'enclenchement (20.8).

3. Boîtier ou unité réceptrice selon la revendication 1 ou 2, **caractérisé en ce que** le logement (20.1) est conçu comme renfoncement en forme de rainure avec deux délimitations latérales se faisant face, sur lesquelles les éléments complémentaires d'enclenchement (20.4) sont formés sous la forme de nervures en saillie ou de renfoncements s'étendant longitudinalement, éléments dans lesquels s'enclenchent les éléments d'enclenchement (55), réalisés sous forme de renfoncements ou à l'inverse de nervures, qui sont disposés sur le côté extérieur des barrettes d'enclenchement (20.8),
ou **en ce que** le logement (20.1) est réalisé sous forme de saillie, sur les flancs latéraux de laquelle, mutuellement opposés et s'étendant en direction longitudinale, sont formés les éléments complémentaires d'enclenchement dans lesquels s'enclenchent les éléments d'enclenchement (55), ici formés sur le côté intérieur des barrettes d'enclenchement (20.8).

4. Boîtier ou unité réceptrice selon la revendication 2 ou 3, **caractérisé en ce que** des rainures de maintien (53), se faisant face et s'étendant longitudinalement, sont ménagées sur le côté intérieur des barrettes d'enclenchement (20.8), rainures dans lesquelles le support de marquage (51) s'enfonce par ses bords longitudinaux.

5. Boîtier ou unité réceptrice selon la revendication 3 ou 4, **caractérisé en ce que** les délimitations latérales du renfoncement en forme de rainure sont pourvues de biais d'introduction (20.3) ou de courbes d'introduction s'étendant en angle aigu l'un vers l'autre de l'extérieur vers l'intérieur relativement à la direction d'insertion de la réglette de marquage (50), derrière lesquels sont disposés les éléments complémentaires d'enclenchement (20.4).

6. Boîtier ou unité réceptrice selon l'une des revendications 2 à 5,
**caractérisé en ce que** la face de visualisation (52.1) est prolongée le long de ses deux côtés longitudinaux, au-delà des départs des branches du U, par des bords d'appui (56),
et **en ce que** le logement (20.1) porte, sur son côté extérieur ouvert, des évidements (20.5) qui sont essentiellement adaptés en largeur et en profondeur aux bords d'appui (56) et qui présentent une butée (20.6) sur leur côté arrière dans la direction d'insertion de la réglette de marquage (50).

7. Boîtier ou unité réceptrice selon l'une des revendications 3 à 6,
**caractérisé en ce qu'**une rainure filetée (20.7) s'étendant longitudinalement est ménagée dans le fond du logement (20.1) conçu comme renfoncement en forme de rainure.

8. Boîtier ou unité réceptrice selon l'une des revendications précédentes,
**caractérisé en ce que** le profilé de cadre porte des régions de surface avant (24, 24') en raccordement aux deux côtés longitudinaux du logement (20.1),
et **en ce que** la région de surface (24) plus proche de l'ouverture (3) se raccorde, par l'intermédiaire d'un décrochement en retrait par rapport à la face avant, à une barrette de butée (25) du genre bride, délimitant l'ouverture (3) en étant parallèle au plan de l'ouverture.

9. Boîtier ou unité réceptrice selon l'une des revendications précédentes,
**caractérisé en ce que** le profilé de cadre est pourvu d'une portion de paroi du boîtier (1)
ou de l'unité réceptrice qui est solidairement formée et qui s'étend en profondeur vers l'arrière relativement à la face avant.

10. Boîtier ou unité réceptrice selon la revendication 9, **caractérisé en ce que** la portion de paroi respective présente plusieurs cavités s'étendant en direction longitudinale, et **en ce qu'**un profilé de cadre supérieur (20), un profilé de cadre inférieur (21) et deux profilés de cadre latéraux (22), tous de même section, sont reliés entre eux par l'intermédiaire de quatre pièces de coin identiques (40), dont les régions de surface avant se raccordent à plat aux régions de surface avant des profilés de cadre (20, 21, 22).
